# EUROPEAN PATENT APPLICATION

(11) **EP 3 106 893 A2**
(43) Date of publication of application: **21.12.2016**
(21) Application number: 15193698.6
(22) Date of filing: 09.11.2015
(51) Int. Cl.: G01R 33/34, G01R 33/3415, G01R 33/48

(54) **METHODS OF DESIGNING MRI RF COILS**

(30) Priority: 28.05.2015 US 201514723779
(71) Applicant: The Royal Institution for the Advancement of Learning / McGill University, Montreal, Québec H3A 0G4 (CA)
(72) Inventor: Farivar-Mohseni, Reza, Montreal, Québec H4A 2L1 (CA)
(74) Representative: Alton, Andrew

(57) **Abstract**

The inventors have established design principles for phased-array MRI coils from the considerations of the target region of the anatomy being evaluated and physical anatomy of the patients. Accordingly, the inventors have demonstrated shape-optimized phased array coils with dense packing of 32 channels for posterior-head imaging exhibiting the SNR gains required to realize not only sub-millimeter fMRI BOLD imaging but also allowing single-shot Gradient Echo - EPI imaging to be performed upon general 3T MRI instruments. At the same time the design techniques address ergonomic considerations of the patient and designing shape-optimized phased-array MRI coils and patient supports that account for variations within the human population arising from factors such as race, gender, etc.

## Description

### CROSS-REFERENCE TO RELATED APPLICATIONS

This patent application claims the benefit of U.S. Patent Application 14/723,779 filed May 27, 2015 entitled "Methods and Systems relating to High Resolution Magnetic Resonance Imaging", the entire contents of which are included by reference.

### FIELD OF THE INVENTION

This invention relates to magnetic resonant imaging (MRI) and more particularly to establishing improved RF coil design to target specific aspects of anatomy and their enhanced assembly and usability.

### BACKGROUND OF THE INVENTION

Magnetic resonance imaging (MRI), nuclear magnetic resonance imaging (NMRI), or magnetic resonance tomography (MRT) is a medical imaging technique used in radiology to investigate the anatomy and function of the body in both health and disease. MRI scanners use strong magnetic fields and radio waves to form images of the body and provide a non-invasive, non-ionizing radiation based technique for medical diagnosis, staging of disease and for follow-up. As a result MRI instruments have a wide range of applications in medical diagnosis and there are estimated to be over 25,000 scanners in use worldwide today with approximately 2,000 sold per annum.

To perform a study the patient is positioned within an MRI scanner which forms a strong magnetic field around the area to be imaged. Most medical applications rely on detecting a radio frequency signal emitted by excited hydrogen atoms in the body, which are present in any tissue containing water molecules, using energy from an oscillating magnetic field applied at the appropriate resonant frequency. The orientation of the image is controlled by varying the main magnetic field through a series of gradient coils. The contrast between different tissues is determined by the rate at which excited atoms return to the equilibrium state.

Accordingly MRI instruments require a magnetic field that is both strong and uniform and whilst historically many instruments exploited fields below 1.5T (1.5 Tesla) today the majority of systems operate at 1.5T although commercial systems are available between 0.2T and 7T. As every human cell contains protons then an MRI instrument can discriminate between body substances based upon their physical properties, for example differences between water- and fat-containing tissues such that MRI scanning is particularly useful in providing highly detailed images of soft tissues. In essence the MRI measures the density distribution of protons within the patient. As the relaxation time of protons can vary and two times are commonly measured which arise as each tissue returns to its equilibrium state after excitation by the independent processes of T1 (spin-lattice) and T2 (spin-spin) relaxation. Accordingly, by adjusting the MRI scan the image contrast of the MRI image may be weighted for different anatomical structures or pathologies. To create a T1-weighted image we wait for different amounts of magnetization to recover before measuring the magnetic resonance (MR) signal by changing the repetition time (TR) of the MRI instrument. In contrast to create a T2-weighted image we wait for different amounts of magnetization to decay before measuring the MR signal by changing the echo time (TE). This image weighting is particularly useful as in these scan fat, water, and fluid are bright. As a result T2 weighting is used in functional MRI (fMRI) which is a functional neuroimaging procedure measuring brain activity by detecting associated changes in blood flow. This technique relies on the fact that cerebral blood flow and neuronal activation are coupled such that when an area of the brain is in use, blood flow to that region also increases.

The most commonly used contrast for fMRI, namely the blood oxygen-level dependent signal (BOLD) discovered by Seiji Ogawa, has allowed researchers to infer neural activity non-invasively within the brain and spinal cord of humans and other animals. BOLD uses the change in magnetization between oxygen-rich and oxygen-poor blood as its basic measure. As this measure is frequently corrupted by noise from various sources and hence statistical procedures are used to extract the underlying signal. Excluding the neural activity itself, BOLD contrast is spatially and temporally limited by at least two noise sources: physiological fluctuations due to breathing and heart pulsation, and image noise due to hardware. Thus by optimizing hardware, we can further improve BOLD contrast and derive more accurate and spatially-specific estimates of neural activity.

It is known that increasing field strength is a sure way to improve BOLD contrast, albeit it can be prohibitively expensive. At ultra-high fields (>7T), enough gain in sensitivity can be achieved to allow for sub-millimeter fMRI. However, such tools are generally unavailable to the majority of vision researchers, and their effective implementation is not straight-forwards (e.g., segmented echo plane imaging (EPI)). Thus a major impediment to advancing the study of the visual cortex (and by extension, the cortex more generally) is the unavailability of tools that would allow the broad community of researchers access to sub-millimeter functional imaging of the visual cortex using methods that are by now conventional, such as single-shot gradient EPI for example. Accordingly, it would be beneficial if a means of increasing the signal-to-noise ratio (SNR) within such BOLD fMRI images on standard MRI instruments with magnetic fields below 7T could be achieved to widen access for researchers, hospitals, etc. to this technique for diagnosis and research. At the same time increasing SNR allows fast MRI scans to be performed thereby offering route to lowering the cost per patient of performing an MRI scan as well as increasing the number of patients who can be diagnosed upon each instrument each year.

Considering the human brain then vision engages the largest portion of the human cerebral cortex, consisting of a hierarchy of well-defined regions that are integrated by links within their functional units. For example, the two functional domains of the primary visual cortex (V1), namely orientation and ocular preference, are represented by columns that span approximately 0.75mm to approximately 1mm. Functional units of higher level areas are also marked by small sub-units. Clusters approximating 1mm in size have been reported in high-level visual areas important for motion perception and similarly small sized modules are believed to represent complex object information in high-level areas important for object recognition. Invasive recordings in animal models have allowed researchers to construct an elegant framework for understanding how vision arises from parallel, hierarchical processing within the visual cortex. This understanding of the visual cortex has served as a framework for understanding the cortex in general (refs), further highlighting the importance of vision research in the neural sciences. However, generalizing the elegant models derived from invasive animal recordings to the human brain is impeded by lack of non-invasive neurophysiological tools for human research to verify these models and establish limitations and exception to them. Accordingly, it would be beneficial to provide non-invasive functional imaging of these small modules requires imaging at resolutions finer than 1mm, a capability that is lacking at the large majority of research sites.

At present these functional units of the human visual system can only be distinguished with very high resolution in vivo and even those have thus far been limited to ultra-high fields (7T). Again, these fMRI measurements are by BOLD contrast and image SNR. Whilst BOLD contrast is stronger at 7T, the image SNR difference between 3T and 7T can be mitigated by designing optimized phased-array RF coils for the transmit / receive sections of the MRI instrument. Within the prior art such phased-array coils have been designed from the viewpoint of designing generalized coil sets for different body regions, e.g. whole body, arm, breast, foot / ankle, and head, where the phased-array coil shape has been defined by the physical geometry of the MRI system in terms of accommodating a predetermined percentage of the population. Accordingly, at present phased-array coil shape has been determined from the ergonomics of accommodating for example 90% of the population with a single coil. However, it would be beneficial to design the phased-array coil from the considerations of the target region of the anatomy being evaluated and physical anatomy of the patients.

Visual cortex imaging presents a particular opportunity for high acceleration rates with good SNR. The bulk of the visual cortex is close to the skull and constrained to the posterior of the head. Local increase of the receiver array density here could result in large gains in SNR and acceleration performance for this restricted region of the brain. In previous studies, the inventors established approximately 40% SNR gain of increasing channel count from 32 to 64 with 65mm diameter loops, and gains of approximately 60% with channel count increase to 96-channel coil with 50mm loops in the cortex near skull. Further reducing loop sizes, while still using room-temperature conductors, forces new design choices in order to maintain sample-noise dominance, namely that the coil housing has to closely follow the subject's head shape.

Accordingly, the inventors have demonstrated shape-optimized phased array coils with dense packing of 32 channels for posterior-head imaging exhibiting the SNR gains required to realize sub-millimeter single-shot Gradient Echo - EPI imaging to be performed on clinical 3T MRI instruments available in a wider range of locations that the limited >7T MRI machines. At the same time the design techniques address ergonomic considerations of the patients.

Additionally the inventors have been able to establish processes for designing shape-optimized phased-array MRI coils and patient supports that account for variations within the human population arising from factors such as race, gender, etc. such that MRI instruments maybe optimized to the indigenous population as well as targeting specific regions of the human anatomy.

Other aspects and features of the present invention will become apparent to those ordinarily skilled in the art upon review of the following description of specific embodiments of the invention in conjunction with the accompanying figures.

### SUMMARY OF THE INVENTION

It is an object of the present invention to mitigate limitations in the prior art relating to magnetic resonant imaging (MRI) and more particularly to establishing improved RF coil design to target specific aspects of anatomy and their enhanced assembly and usability.

In accordance with an embodiment of the invention there is provided a method of designing a magnetic resonance imaging (MRI) coil for a predetermined subset of the population targeting a predetermined region of the human anatomy based upon applying a predetermined mathematical process to MRI images for the predetermined subset of the population and the predetermined region of the human anatomy to derive at least a contour relating to a surface for MRI coil elements forming the MRI coil and a second contour relating to a surface for accommodating the predetermined region of the human anatomy.

In accordance with an embodiment of the invention there is provided a design for a magnetic resonance imaging (MRI) coil, the design targeted for a predetermined subset of the population targeting a predetermined region of the human anatomy.

In accordance with an embodiment of the invention there is provided a magnetic resonance imaging (MRI) coil for use with a predetermined subset of the population targeting a predetermined region of the human anatomy.

In accordance with an embodiment of the invention there is provided a method of assembling a magnetic resonance imaging (MRI) coil comprising mounting a support to a former for the coil, the support comprising a hole essentially parallel to the former when the support is mounted, and tying a thread to attach a coil element for the MRI coil to the former.

In accordance with an embodiment of the invention there is provided a method of adjusting the position of a coil forming part of a magnetic resonance imaging (MRI) coil comprising at least a former by providing a support to which the coil is attached and a translation mechanism for moving the support in a direction at least one of substantially perpendicular to the surface of the former and substantially parallel to the surface of the former.

In accordance with an embodiment of the invention there is provided a method of adjusting the positions of first and second coils forming part of a magnetic resonance imaging (MRI) coil relative to a former and to one another comprising providing a first support to which the first coil is attached and a first translation mechanism for moving the first support in a direction substantially parallel to the surface of the former, providing a second support to which the second coil is attached and a second translation mechanism for moving the second support in a direction substantially parallel to the surface of the former, and providing a third translation mechanism attached to the first and second supports for adjusting the separation between the first and second supports.

In accordance with an embodiment of the invention there is provided a method of establishing the design of at least one of a coil housing and a coil assembly for a magnetic resonance imaging (MRI) coil wherein the design accommodates a patient population comprising those patients within at least one of plus three standard deviations and minus three standard deviations from the normal of the patient population.

In accordance with an embodiment of the invention there is provided a magnetic resonance imaging coil formed using a flexible, resilient non-magnetic wire.

Other aspects and features of the present invention will become apparent to those ordinarily skilled in the art upon review of the following description of specific embodiments of the invention in conjunction with the accompanying figures.

### BRIEF DESCRIPTION OF THE DRAWINGS

Embodiments of the present invention will now be described, by way of example only, with reference to the attached Figures, wherein:
Figure 1 depicts a MRI instrument;
Figure 2 depicts a typical electrical circuit for an MRI instrument;
Figure 3 depicts typical assembled MRI coils according to the prior art;
Figures 4 and 5 depict exemplary flow diagrams for establishing the design of the phased-array coil, coil housing, and neck support for an MRI coil assembly according to an embodiment of the invention;
Figure 6 depicts an exemplary flow diagram according to an embodiment of the invention for selecting patients for clinical studies exploiting enhanced MRI data acquired with MRI coils designed according to embodiments of the invention;
Figure 7A depicts the electronics of a posterior head MRI coil assembly according to an embodiment of the invention;
Figure 7B depicts a posterior head MRI assembly exploiting the design principles according to an embodiment of the invention;
Figure 8 depicts the noise correlation matrix of a constructed 32-channel array coil according to an embodiment of the invention where noise correlation ranges from 0.2% to 42% (13% average);
Figures 9A and 9B depict volume and surface-based visualization of in vivo SNR comparison of a visual cortex coil according to an embodiment of the invention compared to a prior art 32-channel whole-head coil respectively;
Figure 9C depicts the SNR gain of a visual cortex coil according to an embodiment of the invention compared to a prior art 32-channel whole-head coil;
Figure 10 depicts coronal-like maps of 1/g-factors obtained from the dedicated 32-channel visual cortex coil according to an embodiment of the invention and the 32-channel head coil prior art commercial coil.
Figure 11 depicts temporal SNR (tSNR) comparison at 2 mm and 1 mm between a visual cortex coil according to an embodiment of the invention and a commercial 32-channel whole-head coil;
Figures 12A and 12B depict 1 mm and 0.75 mm images respectively from a visual cortex coil according to an embodiment of the invention versus a prior art 32-channel whole-head coil together with BOLD fMRI at 0.75mm isotropic resolution on both coils;
Figure 13A depicts a coil assembly methodology according to the prior art;
Figure 13B depicts a 96 channel receiver only head coil depicting the issues of increasing channel count in prior art MRI coils;
Figures 14A and 14B depict a coil assembly methodologies according to an embodiment of the invention;
Figures 15 and 16 depict coil assembly and tuning methodologies according to embodiments of the invention;
Figure 17 depicts a compact linear motor technology allowing dynamic movement of coil positions according to embodiments of the invention;
Figure 18 depicts a method of addressing the noise within an MRI machine during EPI scan measurements incorporating additional coil elements according to an embodiment of the invention; and
Figure 19 depicts an exemplary flow diagram for establishing a baseline temporal MRI baseline with respect to a predetermined population in response to a stimulus and exploiting said baseline for analysis of potential neurological conditions according to an embodiment of the invention.

### DETAILED DESCRIPTION

The present invention is directed to magnetic resonant imaging (MRI) and more particularly to establishing improved coil design to target specific aspects of anatomy and their enhanced assembly and usability The ensuing description provides exemplary embodiment(s) only, and is not intended to limit the scope, applicability or configuration of the disclosure. Rather, the ensuing description of the exemplary embodiment(s) will provide those skilled in the art with an enabling description for implementing an exemplary embodiment. It being understood that various changes may be made in the function and arrangement of elements without departing from the spirit and scope as set forth in the appended claims.

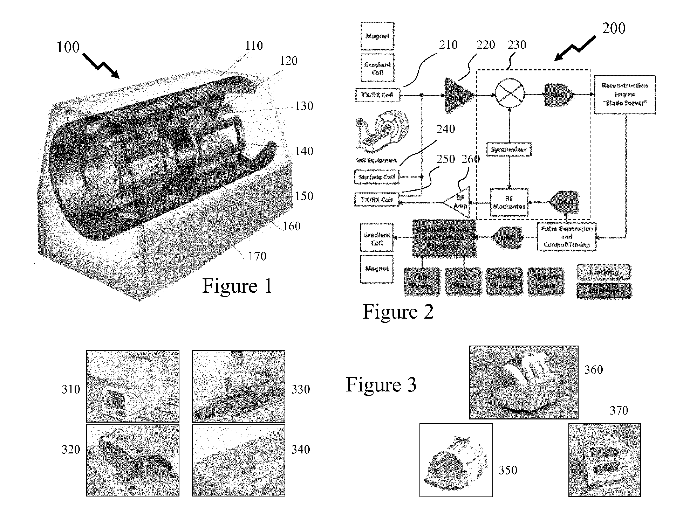

Figure 1 depicts a MRI instrument 100 comprising a scanner body 110 wherein the magnetic field is applied via 4 coils being Y-coil 120, Z-coil 130, X-coil 150, and main coil 160. Y-coil 120 creates a varying magnetic field from top to bottom across the scanning tube whilst Z-coil 130 creates a head to toe varying magnetic field. The X-coil 150 generates a varying magnetic field from left to right across the scanner whilst the main coil 160 surrounds the patient 170 with a uniform magnetic field. The transceiver 140 generates the RF signal to excite the protons within the patient 170 and receives the resulting signals as their excited states decay.

As depicted in Figure 2 a typical electrical circuit for an MRI instrument, such as MRI instrument 100, is depicted comprising first and second Tx/Rx coils 210 and 250 which receives the signal from the decaying protons together with the signal from a surface coil 240, if provided. These signals are coupled to an RF pre-amplifier 220 and therein to an RF processor 230 where they are down-converted, digitized and stored within a reconstruction engine, e.g. a blade server. The down-converter is coupled to a synthesizer generating the mixing signal which is also applied to an RF modulator which receives an analog signal from a digital-to-analog converter which receives digital pulse generation data. The output of the RF modulator is coupled to an RF amplifier 260 before being coupled to second Tx/Rx coil 250. A surface coil 240 is used as a receiver in a crossed-coil arrangement with a conventional circumferential transmitter coil, e.g. first and second Tx/Rx coils 210 and 250, within an MRI. An improved signal-to-noise ratio for objects close to the coil, compared with a conventional circumferential saddle-shaped receiver coil, permits higher resolution imaging of relatively superficial structures such as the orbit, neck, chest wall, and lumbar spine.

Now referring to Figure 3 there are depicted typical assembled MRI coils in first to fourth images 310 to 340 respectively according to the prior art wherein these are designed for use upon different regions of the body. These coils being an 8 element foot / ankle coil, a 16 element coil for bilateral MR angiography, a large field of view adapter for the body, and a 16 element breast coil. Even where coils are intended to the same region of the body different MRI manufacturers have different MRI coils such as depicted in fifth to seventh images 350 to 370 respectively representing head coils offered by GE Healthcare, Hitachi Medical Systems, and Siemens Healthcare respectively. As evident within the prior art the design methodology of such coils is based upon defining a physical surface. For example, US Patent 6,992,486 defines establishing the dimensions of a pediatric MRI coil based upon the 95^{th} percentile whilst US 6,784,665 defines using an average human profile, US 7,999,548 states using appropriate dimensions, and US 7,498,810 defines the coils are simply large enough. Similarly, coil design patents such as US 7,663,367 whilst defining a method of fitting coil layout to a defined surface with constraints such as degree of overlap between coils for minimizing mutual inductance etc. only define the head as a basic structure, namely a semi-sphere.

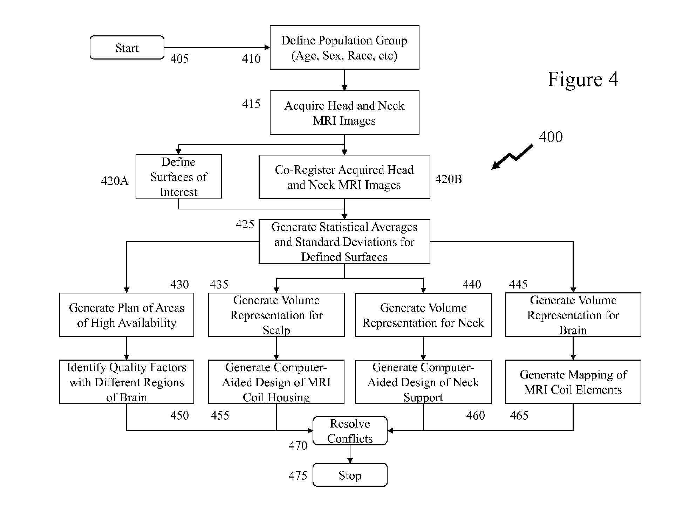

However, referring to Figure 4 there is depicted an exemplary flow diagram 400 for establishing the design of a head phased-array coil, coil housing, and neck support for an MRI coil assembly according to an embodiment of the invention. The process begins in step 405 before progressing to step 410 wherein a population group is defined, such as for example by age, race, and sex. Subsequently, in step 415 head and neck images for the selected population group are acquired. This acquisition may for example be based upon recruiting subjects within the defined population group or by mining MRI databases for patients within the defined population group. From here the process proceeds via parallel steps 420A and 420B respectively. In step 420B the set of head and neck MRI images are co-registered whilst in step 420A the surfaces of interest are defined within these head and neck MRI images. The co-registered images are then employed in step 425 together with the surfaces of interest defined in step 420A to generate the statistical average and standard deviation for each surface, e.g. scalp, neck, and posterior of the brain. From step 425 the process proceeds to steps 430 to 445 in parallel. In step 430 from the data areas of high availability are generated leading to the identification of quality factors for different regions of the brain.

In step 435 the process generates a volume representation of the scalp from the data generated in step 425 which is then used in the computer aided design (CAD) of the MRI coil housing in step 455. In steps 440 and 445 the process generates volume representations of the neck and brain respectively from the data generated in step 425 which are then used in the computer aided design (CAD) of the neck support and mapping of the MRI coil elements in steps 460 and 465 respectively. From each of steps 450 to 465 the process proceeds to step 470 to resolve conflicts before proceeding to step 475 and stopping. Alternatively, the conflict resolution of step 470 involves an iterative feedback process through steps 430 to 465 respectively. Accordingly, process 400 allows for the design of an MRI coil for example optimized to the posterior brain of male Caucasoids aged 40 to 80 for example as opposed to female Mongoloids aged 40 to 80. It would be evident that alternatively the modelling described in respect of steps 435 and 440 may be combined into a single modelling step that provides improved ergonomics and fit.

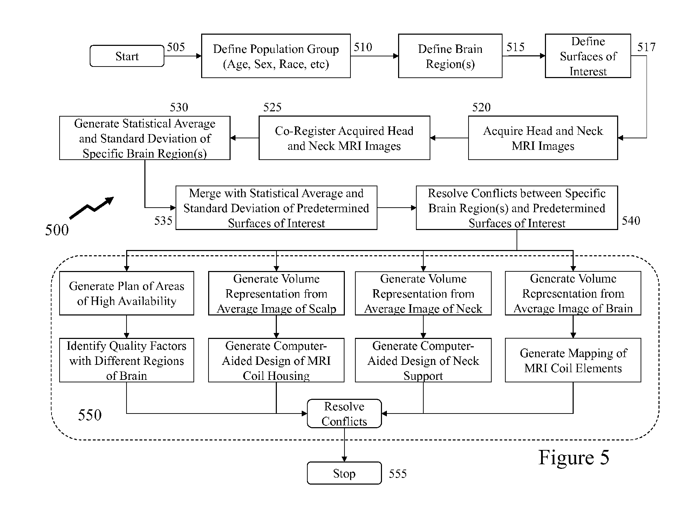

Figure 5 there is depicted an exemplary flow diagram 500 for establishing the design of the phased-array coil, coil housing, and neck support for an MRI coil assembly according to an embodiment of the invention for a predetermined region of the brain. Accordingly, the process begins similarly to flow diagram 400 by starting at start 505 and proceeding to step 510 wherein a population group is defined, such as for example by age, race, and sex. Next in step 515 the region or regions(s) of the brain to be the focus of the MRI imaging are defined and then in step 517 the surfaces of interest defined. From here the process proceeds to step 520 wherein a set of head and neck images for the selected population group are acquired. This acquisition may for example be based upon recruiting subjects within the defined population group or by mining MRI databases for patients within the defined population group. Then in step 525 the set of head and neck MRI images are co-registered and then in step 530 employed to generate to generate the statistical average and standard deviation for the identified specific brain region(s) before being merged in step 535 with the statistical average and standard deviations for each surface of interest.

In step 540 the process then seeks to resolve conflicts between the specific brain images and the predetermined surfaces of interest. Next the process proceeds to process sequence 550 which corresponds to steps 430 to 470 respectively in process flow 400 in Figure 4. Accordingly, process flow 500 in Figure 5 provides as does process flow 400 in Figure 4 the ability to design MRI coils optimized to particular regions of the brain ranging from a specific portion, e.g. the primary visual cortex, multiple regions simultaneously such as primary auditory cortex and primary motor cortex, or the full brain, and particular demographics such as for example female 2-5 year old Australoids or male adult Alsatian dogs.

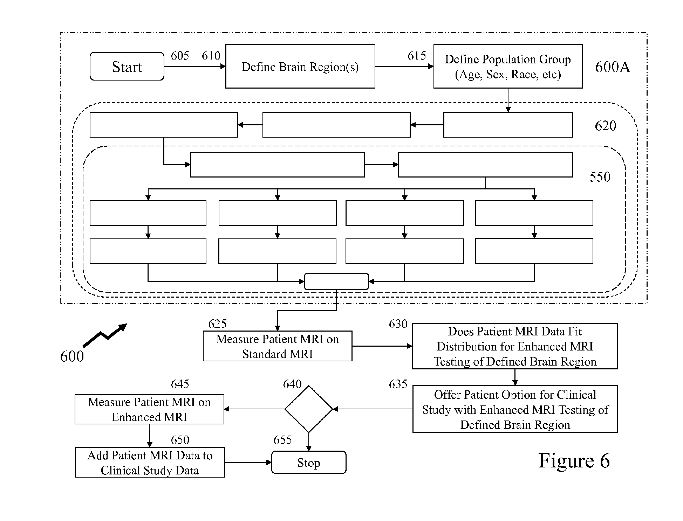

Now referring to Figure 6 there is depicted an exemplary flow diagram 600 according to an embodiment of the invention for selecting patients for clinical studies exploiting enhanced MRI data acquired with MRI coils designed according to embodiments of the invention. The process begins in with process sequence 600A wherein in process steps 605 to 615 it starts, the brain regions are defined and the population group defined. In sub-process sequence 620, comprising steps 520 through 540 and process sequence 550 as depicted in process flow 500 in Figure 5. Accordingly, process sequence 600A results in the establishment of an MRI coil and coil assembly targeting a particular population group and brain region(s). In contrast to process flows 400 and 500 in respect of Figures 4 and 5 respectively the limits for population groups may have been established for a particular demographic. In contrast process sequence 600A may have been established for maximum SNR within a particular demographic wherein the brain and scalp characteristics of the user are such that the brain is closer to the external scalp surface than a broader population base. However, such a demographic may initially have a limited number of subjects within the database of MRI images.

Accordingly, subsequently in step 625 a patient is subsequently given an MRI of their head on a standard MRI system or a more generalized MRI coil designed according to an embodiment of the invention such as described in respect of Figures 4 and 5. Next in step 630 the patient MRI data is compared to the fit distribution of the enhanced MRI design wherein a match results in the patient being offered the opportunity to partake in a clinical study relating to the enhanced MRI testing of the defined brain region(s). If in step 640 the patient decides to become part of the clinical study then the patient has an MRI performed on the enhanced MRI system in step 645 after which the patient's data is added to the clinical study data in step 650 and the process proceeds to step 655 and terminates. Alternatively if the patient declines in step 640 then the process proceeds directly to step 655.

Within the embodiments of the invention described above in respect of Figures 4 through 6 respectively the focus has been to regions of the brain for coil design and placement relative to the brain and for design of the MRI assembly based upon the head and the neck. Extended duration MRI testing where the patient should be motionless ideally requires that patient be comfortable during the scan. However, the principles described in respect of designing an MRI coil targeting a particular region of a human or animal body may be applied to design the coil towards optimizing performance for that region whilst the casing / shell of the MRI assembly is designed for comfort / fit to the population demographic selected. Accordingly, embodiments of the invention in designing towards or at optimal fit for a population allows simultaneously the patient comfort to be improved whilst increasing the SNR. Beneficially, designs with improved fit to the population whilst yielding improved comfort reduce or remove the requirements for foam padding within the space between the MRI coil and the brain, further improving SNR.

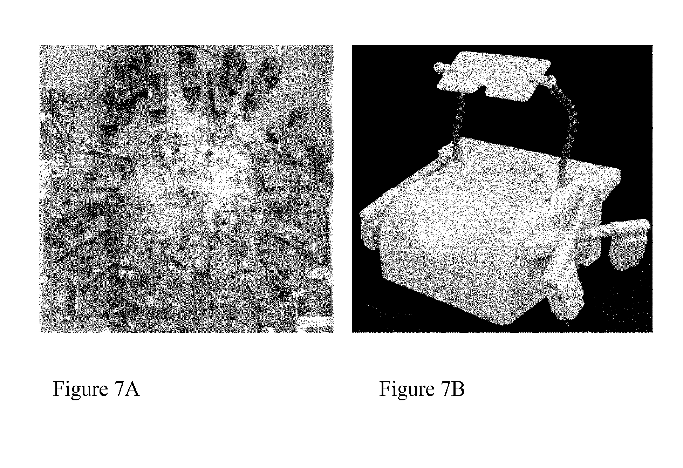

In order to demonstrate the methodologies described above in respect of Figures 4 to 6 the inventor focused to optimizing a coil for visual cortex imaging and accordingly coil element placement was restricted to the posterior of the head allowing for an open-faced assembly topology which is beneficial in vision research as it allows for placement of optics such as mirrors, lenses, patches, etc. Within the resulting MRI assembly depicted in Figure 7B the sockets placed on the housing face to facilitate attachment of such optics are evident on either side together with a rear facing mirror allowing the patient to see.

Within the development of enhanced MRI vision coils are the steps of co-registering the MRI images and processing these to generate the statistical average and standard deviation for the identified specific brain region(s) / scalp and other surfaces of interest in designing wither the coil array or the coil assembly. In order to achieve this a number of non-linear registration algorithms exist within the prior art that operate upon either the MRI image data or the surface-reconstructed models derived from the MRI image data. The inventor has established that whilst these are typically designed to operate on the brain alone that these may also be used with the head data, e.g. neck, scalp and skull data. It is important that the non-linear registration algorithms are "unbiased" either within the co-registration of the set of MRI images or the set of MRI images and a brain atlas. Accordingly, within the embodiments of the invention described within this specification the images are initially linearly transformed to a known template, e.g. a ICBM linear brain atlas, after which the images undergo a non-linear transformation with respect to each other thereby creating in an iterative process a series of intermediate templates that have successively reduced bias towards any one image and are therefore more representative of the whole population. During this process a threshold deformation size is set as a criteria for deciding when the non-linear deformations have plateaued to the point that the resulting template represents the population appropriately.

Additionally there may be criteria to implement for deciding what range of shapes are to be established with respect to the coil array and coil assembly. Of these to determine from the 3-D surface reconstruction of the unbiased atlas is an optimal coil shape. To define the range an approach within an embodiment of the invention is to use the linear and non-linear registration parameters for each image that contributes to the atlas. Optionally, embodiments of the invention may exclude some or all of the normally six rigid parameters, namely the X, Y, Z translations and the rotations around these axes commonly referred to as roll, pitch and yaw. In such embodiments some or all of these will therefore be variables. This being related not to the head shape per se but rather how the head was positioned in the scanner. The remaining six affine terms and any non-linear term would then be employed to define the range of heads.

By calculating the average and standard deviation of the registration parameters from the average, the inventors are able to derive additional sets of parameters that either exaggerate or under-represent the average shape by a certain amount. Accordingly, the shape and range be set, for example, to the average (*x̅*) and plus or minus 3 standard deviations (±3*σ*) from this average (*x̅*). Furthermore, as discussed *supra* the average template may be set for a variety of populations, defined by race, sex, sub-population, age group etc. Population groups could even be defined as being for example those who have smoked for 20 years, those whose have never smoked, those with regular alcohol consumption versus teetotalers, those taking a particular drug.

Further the ability to design a high resolution high SNR coil targeting a specific region of the body, e.g. the brain or the heart, allows also for the potential expansion of MRI instruments into smaller lower cost systems offering specific body region imaging rather than today's whole body MRI systems. Such smaller systems also offer in addition to lower initial system cost potential for lower operational costs, reduced consumable consumption.

### COIL DESIGN AND ASSEMBLY

Accordingly, within the design of the coil former was based on a non-linear atlas of the ICBM dataset (refs). The atlas used included a model of the neck as well, which allowed for optimal placement of the coils around the temporal lobe as well as the design of the contoured surface for resting the neck and head. The comfort afforded by the head and neck contours of the coil former allowed the elimination of padding. This further reduced the space between the MRI coil elements and the head, contributing to greater sensitivity of the coil.

Referring to Figure 7A there is depicted an image of the resulting coil layout. The layout of the overlapping circular coil elements was arranged by a hexagonal tiling pattern, which was printed onto the coil former together with standoffs to mount the preamplifiers and other coil electronic parts. Based upon the targeted region of the visual cortex as a region-of-interest the tile size was appropriately adjusted to meet the desired number of 32 channels within the region defined from the processing of the ICBM database. This yields a loop diameter of 42mm derived from the size of the hexagon tiles, where the loop diameter is slightly larger than the diameter of the circle which inscribes the vertexes of the hexagon. The MRI assembly including its covers was printed in polycarbonate plastic using a rapid prototyping 3D printer.

The 42mm diameter loops were formed from tin-plated 16 gauge oxygen-free high thermal conductivity (OFHFC copper). Each loop contained bridges bent into the wire to allow the coil conductors to cross-over each other although it would be evident that other configurations would be possible. Each loop was symmetrically divided with two gaps, where the discrete components were placed. The discrete components were mounted on small FR4 circuit boards manufactured with a rapid prototyping circuit router then soldered to the loop conductor. These small circuit boards minimize mechanical stress between the loop wires and the ceramic capacitors. The tuning capacitor circuit board contains a variable capacitor (*C*₁) to fine-tune the loop resonance to 123.25MHz. The output circuit-board incorporates a capacitive voltage divider (capacitors *C*₂ and *C*₃) to impedance match the element's output to an optimized noise matched impedance, *Z_{NM}*, desired by the preamplifier. Additionally, the output circuit board used an active detuning circuit across the match capacitor (*C*₂) consisting of an inductor (*L*) and a PIN diode in order to provide a parallel resonant circuit at the Larmor frequency when the diode is forward biased. Thus, when the PIN diode is forward biased (transmit mode), the resonant parallel circuit (*L·C*₂) inserts a high impedance in series with the coil loop, blocking current flow at the Larmor frequency during transmit.

To transform the preamplifier input impedance to a high-series impedance within the loop (preamplifier decoupling), it was first transformed it to a low impedance (short-circuit) across the parallel circuit (*L·C*₂) tuned to the Larmor frequency. This parallel circuit (*L·C*₂), in turn, introduces a high-serial impedance in the coil loop. In this mode, minimal current flows in the loop and inductive coupling to other coils is minimized despite the presence of residual mutual inductance. Preamp outputs were connected to a cable trap to suppress common mode currents and to avoid interaction with the radiofrequency (RF) transmit system.

The coil was shaped to a non-linear average of the head-neck T1-weighted images in the ICBM dataset, allowing for optimal posterior head coverage while providing good neck support, thereby minimizing the need for cushions as evident from the view of the assembled MRI coil in Figure 7B. Thirty-two ∼40mm symmetric circuits were constructed from copper wire with matching and active detune circuits as depicted in Figure 7A. Assessment of the coil assembly was verified through bench measurements performed using the known techniques in the prior art of element tuning, active detuning, nearest-neighbor coupling and preamplifier decoupling for each coil element. Additionally, the ratio of unloaded-to-loaded quality factor (*Q_{U}*/*Q_{L}*) was obtained with a coil element under test placed both external to the array assembly and within the populated but detuned array.

Active detuning was measured with a *S*₁₂ measure between two decoupled inductive probes of approximately - *80dB* such that there were slightly coupled to the array element under test. Nearest neighbor coupling was measured using a direct *S*₂₁ measurement between pairs of elements using coaxial cables directly connected to the preamplifier sockets of the two elements under test. The overlap between nearest neighbors was empirically optimized, while watching *S*₁₂ measure between the two loops under test. When measuring the *S*₂₁ between an adjacent pair, all other elements of the array were detuned. Preamplifier decoupling of a given loop was measured with all other loops detuned as the change in the double-probe *S*₂₁ when the preamplifier socket was first terminated with the powered low impedance preamplifier and secondly with a power matched terminator. Nearest neighbor decoupling was achieved by overlapping the coils to the order of approximately - 15*dB*, with further and next-neighbor decoupling achieved by the preamp decoupling to approximately -19*dB*.

### MRI DATA ACQUISITION AND RECONSTRUCTION

Data were acquired on a 3T clinical MRI scanner, a MAGNETOM Tim Trio by Siemens Healthcare, a product exploiting total imaging matrix (TIM®) technology. SNR maps were acquired using 3mm isotropic proton density (PD) weighted Fast Low Angle SHot (FLASH) images (*TR* = 300*ms*, *TE* = 15*ms, α* = 20°). The array performance was tested in accelerated fMRI acquisitions using single-shot GE-EPI with 0.75*mm* isotropic resolution, a 214 x 214 matrix, 25 slices, *TE* = 31s, TR = 3*s*, *R =* 8, *PF* = 6/8. With slices oriented near-coronal, within a single patient measurement a total of 110 images of the posterior occipital cortex were captured whilst the subject viewed a periodic stimulus, a movie comprising 30s ON, 30s OFF. These images slice-timed, corrected for patient motion, and temporally de-trended but were not smoothed. Subsequently conventional general linear model (GLM) analysis was carried out using Analysis of Functional NeuroImages (AFNI), an open-source environment for processing and displaying functional MRI data. A maximum amplitude gradient strength of 40 mT/m and a maximum slew rate of 200 mT/m/ms could be applied. Signal-to-noise ratio, g-factor, and noise correlation measurement were obtained from in vivo scans. These measurements were compared to a commercially available 32-channel head coil using the same subject with identical slice prescription (atlas-based auto-align). The inventors employed gradient-echo images (TR/TE/flip=300ms/15ms/20°, slice thickness=3mm, slice count: 35; matrix: 64×64, FOV:192×192 mm2, Bandwidth (BW) = 200 Hz/Pixel) to acquire a three-dimensional (3D) SNR map. Noise covariance information was acquired using the same pulse sequence but with no RF excitation. The SNR maps were calculated using the noise-covariance weighted root sum-of-squares (cov-RSS) of the individual channel images, where the weights utilize coil sensitivity maps and noise covariance information. The SNR data was co-registered to a T1-weighted multi-echo MPRAGE, see for example van der Kouwe et al in "Brain Morphometry with Multiecho MPRAGE" (Neuroimage, Vol.40(2), pp.559-569) (TR = 2.51s, TI=1.2s, flip=7°, four echoes with TE=1.64 ms, 3.5 ms, 5.36 ms, and 7.22 ms; an 192 × 192 × 176 matrix with 1-mm isotropic voxel size, BW = 651 Hz/pixel, R=3), and projected onto the visual cortex inflated surface. A 3-D surface representation was reconstructed from the MEMPRAGE image and used to visualize the SNR data on the cortical surface. The SENSE g-factor maps were calculated from the complex coil sensitivities and noise covariance matrix to assess noise amplification in parallel image reconstruction. For g-factor calculations we used an oblique-coronal slice prescription as also applied in visual cortex fMRI acquisitions schemes.

For the BOLD / temporal SNR (tSNR) acquisition a standard single-shot gradient-echo EPI protocol was used at two different resolutions, 1mm and 2mm, with TR/TE/flip=250 ms/33 ms/33°, 3x1 mm images acquired interleaved with 0.1mm slice gap, FOV 128x128mm, M: 128x128mm, BW=1086Hz/pixel, echo spacing 1.05ms, R=3 acceleration with fat saturation. For the 2mm images the same parameters were used with the following exceptions M:64x64, 3x2mm thick slices acquired with 0,.2mm slice gap. During each measurement, 320 volumes were acquired from the posterior occipital cortex while subjects viewed two blocks of 10 seconds visual stimulation, followed by 30 seconds of rest. The 240 volumes corresponding to the rest period of the hemodynamic response function were used for the tSNR measurements (26). The tSNR measurements were carried out on the visual cortex-optimized coil as well as prior art whole-head 32-channel coil -therefore a total of four tSNR measurements were carried out. To calculate tSNR, measurement volumes were first assessed for motion using AFNI's (27) 3dvolreg motion correction tool, but motion was negligible in all runs and therefore motion correction was not applied. The mean of all images was then divided by the standard deviation of the images voxel-wise. A manually-drawn mask was used to exclude non-brain voxels in the tSNR estimates.

The coil underwent a battery of tests that assessed safety for the subjects. To check whether active detuning during transmit phase was sufficient, the power needed to achieve the adjustment flip angle (180°) was measured in a phantom with and without the receive coil present. The ratio of these two measures was required to be between 0.9 and 1.1. The coil was also tested for heating. After switching off the SAR monitor and the gradient stimulation monitor, measurements were made of the temperature increase in the coil caused by RF transmit power being absorbed by the receive circuitry or heating by induced currents from the gradient switching. The detuned coil and phantom were scanned for 15 min with a body coil *B*₁-field of 30 µT applied at a 10% duty cycle and repetition time of 60 ms; an RF power level well above the SAR limit.

Sub-millimeter functional MRI at 3T was successfully carried out using the visual cortex coil. For these fMRI acquisitions a standard single-shot gradient-echo EPI protocol was used to acquire images at 0.75 mm isotropic resolution with the following parameters TR/TE/FA=3000 ms/31 ms/90°, fat saturation, FOV: 160 mm × 160 mm, M: 214 × 214, partial Fourier = 6/8, R=4, BW=834 Hz/pixel. The images were reconstructed with the standard online Siemens EPI and GRAPPA reconstruction. During the acquisition, the subject viewed a stimulus that was back projected on a translucent screen at the back of the scanner bore and reflected onto the eyes with a mirror placed just above the head coil. The stimulus consisted of an alternating pattern of 30 s of the movie "Despicable Me" with 30s blank screen, with the alternation occurring 5 times. The images were slice-time and motion-corrected but were not smoothed. Statistical parametric maps were generated using AFNI's 3dDeconvolve program, which fits a model time-series consisting of the canonical hemodynamic response function convolved with the movie onsets. The exact same procedure was followed for acquiring and analyzing comparison data from the 32ch whole-head prior art coil. In order to directly compare the two datasets, the results of the analysis from the visual cortex coil were rigidly co-registered to the whole-head data.

Accordingly the inventor derived maps of the obtained visual cortex SNR of the constructed coil and a commercial 32-channel whole brain array coil. The 3D SNR map comparison were measured with the same subject. In the target region the dedicated visual cortex coil shows a 2-fold SNR improvement compared to the whole head 32-channel coil. The inventors also established comparison inverse local G-factor maps in an oblique-coronal plane (as typically used for visual cortex fMRI) for one-dimensional and two-dimensional accelerations derived from coil sensitivity profiles and noise correlations from the in-vivo measurements. The peak G-factor reflected the worst case scenario regarding noise amplifications during parallel image reconstruction. The dedicated 32-channel visual cortex coil produces overall lower G-factors, roughly providing one additional unit of acceleration for a given noise amplification factor, when compared to a 32-channel head coil. For example, for R = 3 in the interior-superior direction, the constructed coil showed a reduction in noise amplification. The combination of reduced G-factor and improved occipital cortical SNR translates to improved image quality in visual fMRI studies.

### RESULTS

The 42 mm diameter coil elements showed a *Q*_{U}/*Q*_{L}-ratio of 273/114=2.3 and 258/123=2.1, for a single isolated coil loop and a loop surrounded by its six non-resonant neighboring elements, respectively. *Q*_{U}/*Q*_{L}-ratio shows that the sample and component losses contribute almost equally to the image noise, for these small diameter loops with limited tissue volume under each element. In addition, upon sample loading a frequency drop of 0.3 MHz was measured with an isolated coil element.

All safety tests were successfully passed. For assessing active detuning efficiency, the ratio of transmitted power with and without the coil present was 1.03. The temperature increase in the coil caused by RF transmit power being absorbed by the receive circuitry or heating by induced currents from the gradient switching was <2 °C. Stability test indicated a peak-to-peak variation of 0.2% over a 15 × 15 pixel ROI for 500 time-points for 3x3x5 mm resolution EPI (after de-trending).

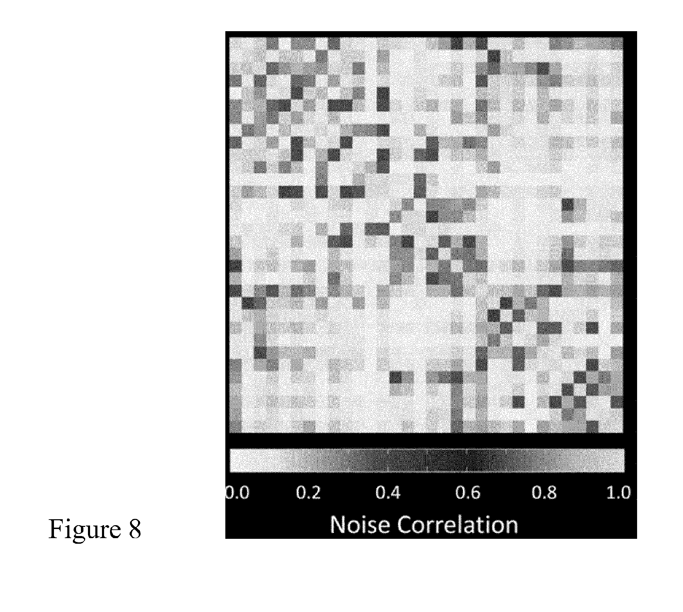

Figure 8 shows a representative noise correlation matrix obtained from noise-only phantom images. The noise correlation ranged from 0.2% to 42% with an average of 13%. Bench tests showed a range of decoupling between nearest neighbor elements from -12 dB to -21 dB with an average of -14 dB, which is improved by additional reduction of 19 dB via preamplifier decoupling. Furthermore, active PIN diode detuning resulted in 40 dB isolation between tuned (PIN diode forward biased) and detuned states (PIN diode reverse biased) of the array elements.

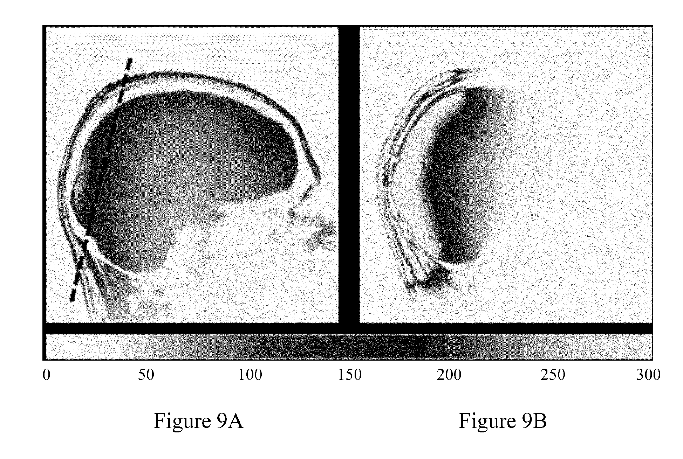

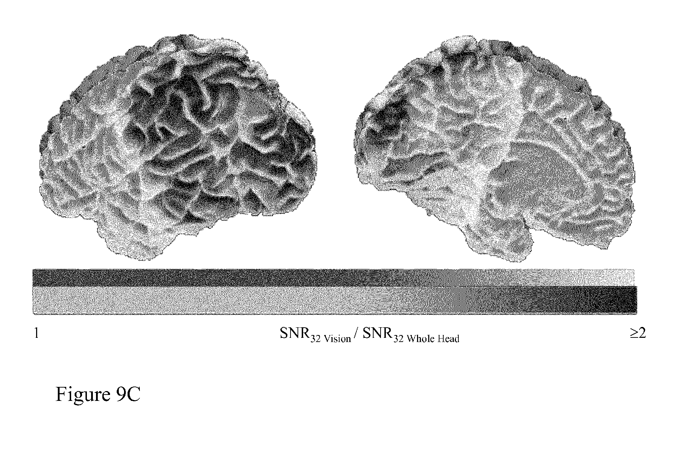

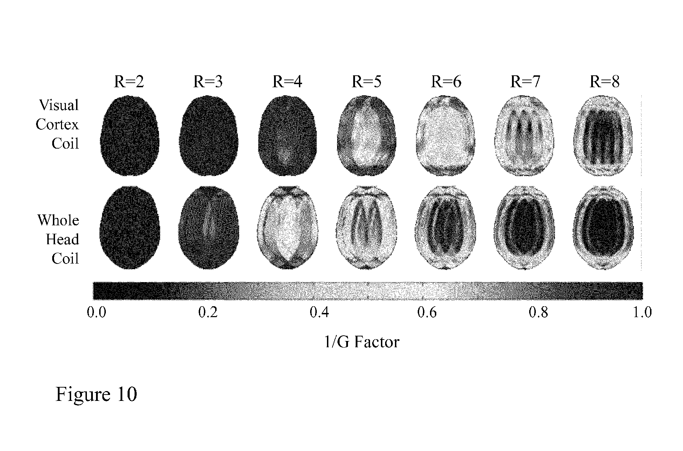

Figures 9A to 9C depict volume and surface-based visualization of *in vivo* SNR comparison of the visual cortex coil according to an embodiment of the invention compared to a prior art 32-channel whole-head coil. Figures 9A and 9B depict the SNR maps for the whole-head versus the visual cortex coil, respectively. The dashed line in Figure 9A depicts the slice position for the G-factor maps presented in Figure 10. Figure 9C depicts that SNR gain of the visual cortex coil, as a ratio of the whole-head coil SNR. The optimizations employed in the visual cortex coil resulted in a 2-fold SNR improvement near the coils, and approximately 50% improvement elsewhere in the visual cortex.

Figure 10 shows the comparison of inverse local g-factor maps in an oblique-coronal plane (as typically used for visual cortex fMRI) for one-dimensional accelerations derived from coil sensitivity profiles and noise correlations from the in vivo measurements. The dedicated 32-channel visual cortex coil according to an embodiment of the invention produces overall lower g-factors, roughly providing a 1.5 additional unit of acceleration for a given noise amplification factor, when compared to a 32-channel head coil of the prior art. For example, for R = 3 the constructed coil showed an average of 28% less noise amplification. The combination of reduced G-factor and improved occipital cortical SNR translates to improved image quality in visual fMRI studies.

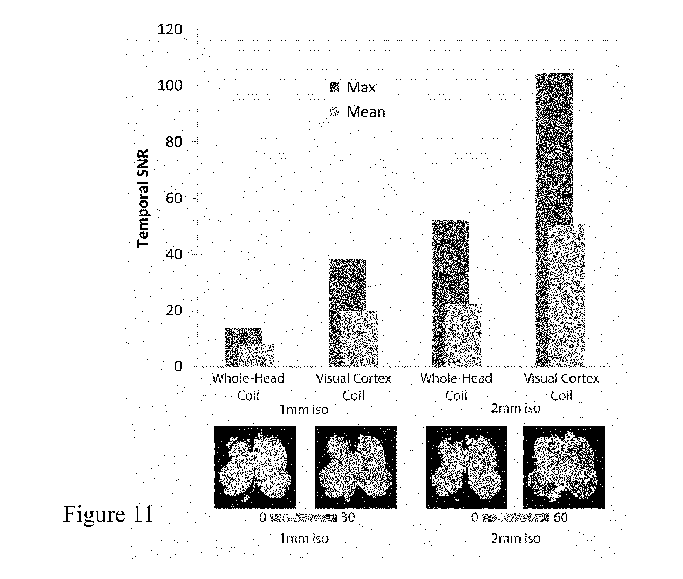

Figure 11 depicts the mean and maximum tSNR estimates for 1 mm and 2 mm isotropic resolution GE-EPI acquisitions made with the prior art 32-channel whole head coil and the visual cortex coil according to an embodiment of the invention, as well as representative tSNR maps for each of those measurements. Temporal SNR in the posterior occipital cortex was approximately 2-fold higher on average with the visual cortex coil than the vendor supplied whole-head coil. The maximum SNR estimates in this brain area are even higher, approximately 2.5-fold greater in this cortical area with the optimized coil than with the standard 32-channel whole-head coil. The tSNR gain from the whole-head to the visual cortex coil was higher for the 1 mm acquisitions, likely due to decreased partial volume effects at the higher resolution.

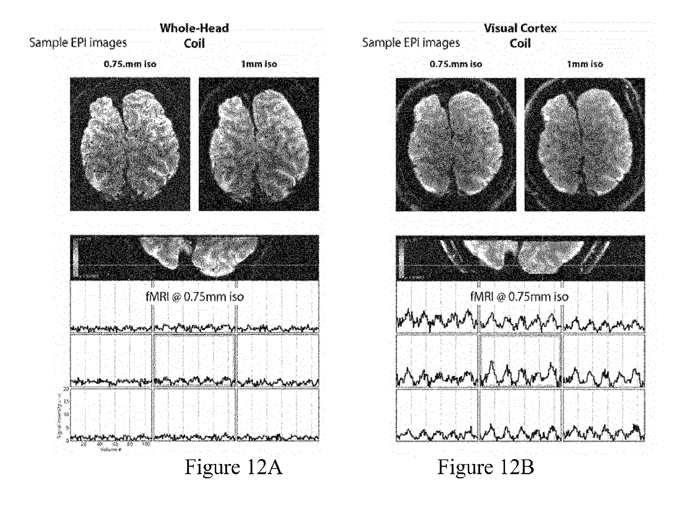

Sub-millimeter fMRI at 0.75 mm isotropic resolution yielded excellent image quality as evident with the sample EPI images in the upper portion of Figure 12B and were usable for fMRI measurements. Without spatial smoothing, activity-related signal changes were observed in the posterior occipital cortex in response to the 30s on, 30s off movie stimulus, suggesting that even with such small voxels, fMRI responses can be robustly measured with appropriate hardware at 3 T as evident from the images in Figure 12B lower portion. In contrast to the robust fMRI signal change that was measureable with the visual cortex coil according to an embodiment of the invention, the same paradigm resulted in negligible pattern of activity when measured using the whole-head coil according to the prior art as evident from the images in Figure 12A lower portion.

### ANALYSIS

As evident from the results presented *supra* the shape-optimized visual-cortex targeted 32-channel receiver array coil according to an embodiment of the invention, despite weighted design choices that sacrifice flexible imaging planes for higher SNR and better acceleration, shows that dense packing of small loops covering the visual cortex yielded a doubling of SNR in this region of the brain. The SNR gains were sufficient for sub-millimeter fMRI at 3T, opening the way for new studies on the microstructure of cortical visual function within general MRI instruments globally.

The inventors previous studies with dense arrays (64-channel and 96-channel) only yielded between 40% to 60% cortical SNR gain over a 32-channel whole-head, respectively, despite their coils utilizing loops that were of similar material and electronics, although the 42mm diameter loops within the coil array according to an embodiment of the invention were smaller compared to the 96-channel whole-head coil of the inventor's prior art. However, the inventors whole-head coils did not specifically optimize the shape of the housing unlike the visual cortex coil array according to an embodiment of the invention. Accordingly, the inventors have established through an atlas based design methodology of patient physical structure that shape optimization is at least as important as electronic considerations in boosting SNR in phased-array coil design, particularly when one region of the brain is targeted at the cost of the flexibility of whole-head imaging.

The 32-channel visual cortex coil according to an embodiment of the invention was designed for stability in both highly accelerated and high-resolution functional imaging on a clinical 3T scanner for robust daily use across a wide variety of medical facilities rather than a restricted number of 7T scanners globally. The array coil performance was evaluated via bench-level measurements such as *Q_{U}*/ *Q_{L}* -ratios, tuned-detuned isolation, and neighbor coupling, whilst system-level validations included component heating, transmit field interactions, and stability measurements. Further, *in vivo* brain performance tests, were carried out by pixel-wise SNR maps, g-factor maps, noise correlation, tSNR, as well as sub-millimeter functional imaging.

A number of technical issues arise in the implementation of large channel-count arrays employing relatively small element sizes (such as the 42 mm diameter elements used here). In particular, the inter-element decoupling becomes more difficult and time-consuming as the element density increases. Additionally, maintaining a sufficient *Q_{U}*/*Q_{L}-*ratio becomes problematic. For example, while a whole-head 32-channel prior art coil with a loop diameter of ∼90 mm can be constructed out of flexible circuit material, array coils with smaller sized elements show significant eddy current losses in the flat circuit board conductors of the neighboring elements, leading to a lower *Q_{U}*/*Q_{L}* -ratio and diminished SNR. Spatially sparse wire conductors and carefully chosen location of the preamplifiers and their motherboards with minimum separations from loop elements has been shown by the inventors to reduce the losses in these copper components. Also, the ability to mechanically optimize the overlap between two neighboring loops by bending the wire facilitated the element decoupling procedure. Despite these optimizations, the unloaded *Q* of a given loop was measurably diminished when the loop under test was placed in an array configuration, suggesting that losses within the conductors of neighboring elements were still present. Nonetheless, the *Q_{U}lQ_{L}* = 2.1 for coils according to embodiments of the invention suggests that electronic noise and the sample noise are equally distributed. A frequency drop of 0.3 MHz upon sample loading, measured with an isolated coil element (no neighbors present) of the 32-channel coil according to an embodiment of the invention, indicates some imbalances in how the sample and coil interact through electric and magnetic fields. This source of loss could be compensated with more equally distributed series tuning capacitors to further balance the electrical field around the loop. When loop sizes are small, additional series capacitors increase the effective series loop resistance, which in turn reduces SNR. The practical implementation of higher capacitor counts in high-density array coils is also seriously challenging.

To image the function of small brain structures accurately, both high-resolution scans and high SNR values are required. The BOLD-fMRI contrast-to-noise ratio can be expressed as the product of the tSNR and the fractional change in relaxivity, *R*2*, during activation (Δ*R*2* / *R*2*). Since the latter is determined mainly by biology, tSNR can be increased by improving acquisition hardware and/or field strength. The latter is both expensive and introduces its own challenges, while hardware optimization can be economical and effective, albeit restricted to a region of interest, in this case, the visual cortex. For high-resolution accelerated scans, this means optimizing the intrinsic detection sensitivity (the effective *B*₁ of the array coil), the g-factor of the accelerated image while maintaining temporal stability.

Temporal stability is critical for highly accelerated imaging. For example, GRAPPA kernels are trained on multi-shot data to match the echo-spacing of the accelerated data and multi-shot sequences are intrinsically more sensitive to temporal instabilities than single shot sequences. This means that temporal instabilities inadvertently reduce tSNR both directly by modulating the single shot data and indirectly by increasing the g-factor. Therefore high-resolution fMRI acquisitions using GRAPPA demand both maximal stability and sufficient image encoding capabilities in order to allow for detection of small (Δ*R*2* / *R*2***)*.*

The developed coil according to an embodiment of the invention provides both a high time-course stability of 0.2% peak-to-peak and overall low noise amplification when using fMRI relevant acceleration factors (R=3, R=4). Furthermore, the high SNR of the multiple small elements can be invested into sub-millimeter resolution, which brings the tSNR into a thermal noise dominated regime by reducing the physiological noise (the amplitude of which scales with the MR signal strength in a given voxel). Therefore, acquisitions at higher resolutions have the additive advantage of reducing the associated time-series artifacts caused by unwanted physiological noise contributions (cardiac and respiratory fluctuations) resulting in increased sensitivity. In addition to increased localized activations and the ability to resolve the visual cortex in its smallest modules, higher resolution fMRI acquisitions allow for less through-plane signal dephasing, limited partial volume effects and improved biological point-spread-function (PSF) of the BOLD effect. This isolation process and the achieved high spatial specificity, ultimately, allow us a better understanding of intrinsic properties of functional networks in both stimulus-related and spontaneous neural activities.

### COIL DESIGN VARIATIONS

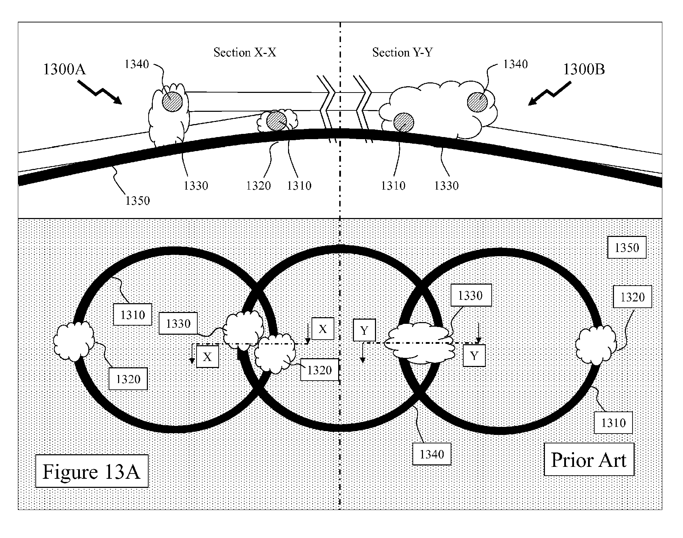

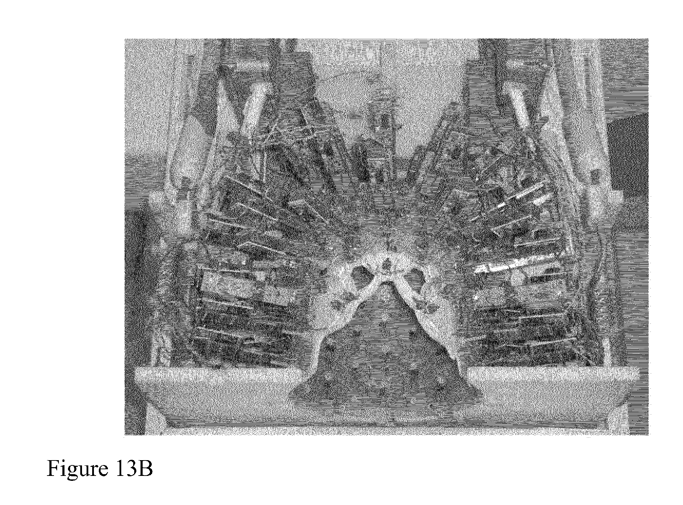

Now referring to Figure 13 there is depicted a coil assembly methodology according to the prior art in first and second sides 1300A and 1300B respectively. Considering the lower portion of first side 1300A there is depicted plan view of a first coil 1310 disposed below a second coil 1340 as part of an MRI coil array wherein other coils within the phased array coil have been omitted for clarity. These are disposed upon a former 1350. Each of the first and second coils are attached by first and second joints 1320 and 1330 respectively and are implemented using a glue to retain the first and second coils 1310 and 1340 to the former 1350. As depicted second joints 1330 are thicker as the second coil 1340 is disposed atop the first coil 1310. In other embodiments of the invention, such as that employed by the inventors in forming the coils with "bridges" the second coils 1340 may be attached using a joint similar to first joint 1320 where the second coil 1340 is close to the former 1350. Alternatively, as depicted in second side 1300B the first and second coils 1310 and 1320 are only attached where they overlap or are collocated.

It would be evident therefore that such an assembly becomes increasing difficult as the number of coils within the phased array increases, where currently 4, 8, 16, 20, and 32 element coils are common. Whilst 48, 64, and 128 element coils are now being offered on newer high end systems these are typically only based upon large regions of the human body such as 64 channel head and neck, 128 channel whole body etc. In other instances high element count MRI coils for example are composed of multiple smaller element count coil arrays with angular gaps between them, e.g. 30 degree gaps. These issues do not stop with the attachment of the coils to the former as subsequently for each coil there are the associated variable capacitors for tuning the resonance frequency, voltage dividers and LC impedance matching circuit to the amplifier with their associated cabling. This is evident from the image in Figure 13B of the 96 channel receive only head coil according to Wiggins et al. in "96-Channel Receive-Only Head Coil for 3 Tesla: Design Optimization and Evaluation" (Magn. Reson. Med., Vol. 62(3), pp.754-762).

Accordingly, issues of assembly such as access of user's fingers, faulty glue joints, glue induced stress, glue line delamination etc. as well as options for repair result in significantly increasing costs and complexity of assembly thereby limiting today increasing coil counts within the same region of the human body for example. However, it is well known that increasing element coil counts with smaller coil dimensions results in improved SNR and improved resolution. Accordingly, it would be beneficial to provide enhancements in the assembly of high element count MRI coils.

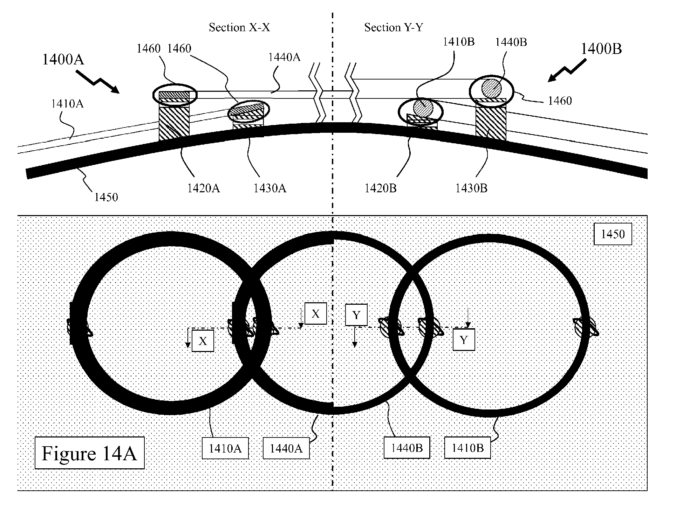

Now referring to Figure 14A there is depicted a coil assembly methodology according to an embodiment of the invention in first and second sides 1400A and 1400B respectively. Considering the lower portion of first side 1400A there is depicted plan view of a first planar coil 1410A disposed below a second planar coil 1440A as part of an MRI coil array wherein other coils within the phased array coil have been omitted for clarity. These first and second planar coils 1410A and 1440A respectively are disposed upon a former 1450. Each of the first and second planar coils 1410A and 1440A respectively are attached via first and second supports 1420A and 1430A respectively via threads 1460. Formed with the top section of each of the first and second supports 1420A and 1430A respectively are holes, not labelled for clarity, that allow the threads 1460 to be threaded through below a planar coil and then tied above the planar coil. It would be evident that in this manner the planar coils may be assembled to the former 1450 and either loosely restrained before all threads are sequentially tightened or the threads may be tied tight and then should an adjustment be required they can be simply removed and replaced.

Now referring to the second side 1400B of Figure 14A then the same support and attachment concepts are depicted for first and second circular wire coils 1410B and 1440B which are mounted to first and second supports 1420B and 1430B respectively and retained during assembly via threads 1460. Optionally, once the coil assembly is complete the threads may be locked through application of an adhesive before the coil assembly is mated to the coil assembly body. Within another embodiment of the invention as each coil is placed upon a support a command cure epoxy may be applied such that once the assembly is complete the command cure epoxy can be cured and the coils attached to the supports allowing the threads to be cut and / or removed. Examples of command cure epoxies may include, for example, those curing through polymerization from UV / blue light irradiation or those with UV priming and curing from sources such as microwave radiation to heat guns with rapid cure time, e.g. US Patent 7,235,593. Alternatively, a low temperature solder may be employed such as *In*₅₂*Sn*₄₈ (commonly referred to as In51) and *In*₅₀*Sn*₅₀ (commonly referred to as Cerroseal35) which offer melting points without requiring use of lead at approximately115°C. Others may include Field's metal (*In*_{51.0}*Bi*_{32.5}*Sn*_{16.5}) at 60°C, Cerrobend (*Bi*₅₀*Pb*_{26.7}*Sn*_{13.3}*Cd*₁₀) at 70°C, and Bi52 (*Bi*₅₀*Pb*_{26.7}*Sn*_{13.3}*Cd*₁₀) at 70°C. Alternatively other adhesives, solders, epoxies etc. may be applied according to other embodiments of the invention.

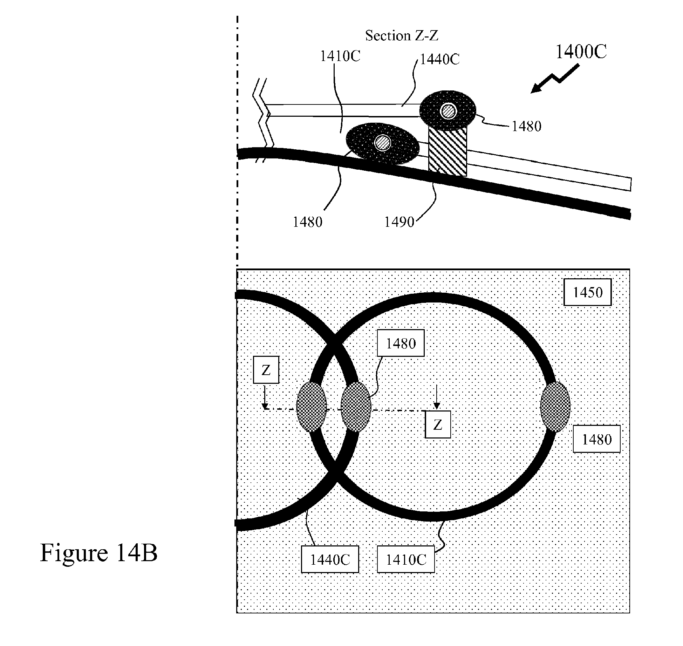

Referring to Figure 14B there is depicted a coil assembly methodology according to an embodiment of the invention in schematic 1400C. Considering the lower portion of schematic 1400C then there is depicted plan view of a wire coil 1410C disposed below a second wire coil 1440C as part of an MRI coil array wherein other coils within the phased array coil have been omitted for clarity. These first and second wire coils 1410C and 1440C respectively are disposed upon a former 1450. Each of the first and second wire coils 1410C and 1440C respectively are attached via beads 1480 through which the first and second wire coils 1410C and 1440C respectively have been threaded within holes formed through the body of the beads 1480. As depicted in cross-section Z-Z the bead 1480 attaches directly to the former 1450 for the first coil 1410C. The bead 1480 for second coil 1440C is attached via support 1490. The beads 1480 may be plastic with the diameter of the hole being a fit to the outer diameter of the wire or the hole may be dimensioned to suit a planar coil. Accordingly, the beads allow for the placement of the coils and their locations may be determined on the coil housing prior to assembly during the three-dimensional modelling and printing processes. In some embodiments of the invention the locations may be defined by elements within the three-dimensional printing such that the beads are located and attached via an epoxy for example.

Within the embodiments of the invention the former to which the coils are attached is rigid or semi-rigid within the prior art and the embodiments of the invention described with respect to Figures 4 through 7B respectively as the coil array is being formed to a predefined surface. However, within other embodiments the coils do not have to be attached to rigid or semi-rigid formers as it is evident from the work of the inventors that different individuals present different separations of, for example, the primary visual cortex from the exterior of their scalp both between different population groups and between individuals. Accordingly, it would be beneficial to provide for a coil assembly that allowed some degree of deformation so that profile of the coil assembly followed closer to the patient's actual external scalp surface than the an averaged profile such as achieved through process flows 400 and 500 in Figures 4 and 5 respectively or the methodologies described *supra* in respect of the prior art.

One such methodology would be to employ a deformable preform within a coil assembly such as described in respect of Figures 14A and 14B *supra* wherein deformation of the preform 1450 can be performed within a certain range as the coils are restricted essentially within the vertical plane by the heights of the support pairs such as 1420A / 1430A and 1420B / 1430B respectively such that their relative vertical separation is constant. It would also be evident that a deformable coil array would be easier exploiting thin foil coils according to embodiments of the invention rather than the thicker stiffer wire coils. Deformable (compliant) materials may include, but not be limited to, rubber, neoprene, synthetic rubber, plastic, vinyl, polyethylene etc.

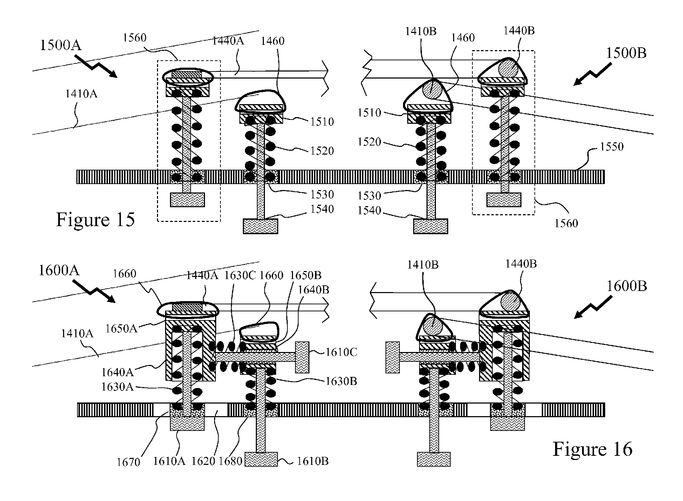

Referring to Figures 15 and 16 there are depicted coil assemblies providing for adjustment and tuning methodologies according to embodiments of the invention. With reference to Figure 15 there is depicted in first and second sides 1500A and 1500B a concept for adjustment of coil position either in conjunction with a rigid or non-deformable former or with a deformable / compliant / pliable former according to an embodiment of the invention is presented. The first and second sides 1500A and 1500B differ only in flat copper first and second coils 1410A and 1440A respectively are employed in first side 1500A whilst wire first and second coils 1410B and 1440B are employed in the second side 1500B. In each instance the coils are mounted upon an actuator 1560 comprising a bead mount 1510 through which a thread 1460 is threaded and tied so that the coil is retained against the surface of bead mount 1510. The bead mount 1510 is coupled to a drive screw 1540 which act in conjunction with a threaded insert 1530 fitted within the former 1550 to adjust the offset of each coil from the former 1550. To maintain contact of the bead mount 1510 to the drive screw 1540 a spring 1520 is retained within the bottom surface of the bead mount 1510 and threaded insert 1530 to pull the bead mount 1510 against the drive screw 1540. Optionally, bead mount 1510 may be attached to the drive screw 1540 without use of the spring 1520 to retain the bead mount 1510 in position. Other mechanical configurations to provide the desired mechanical function may be evident to one of skill in the art from the plurality of mechanical systems within the prior art. Given the nature of the environment then the drive screw 1540, bead mount 1510, spring 1520, threaded insert 1530, etc. may be formed from non-magnetic materials or materials with minimal / no interaction within the MRI system including, but not limited to, alumina, toughened alumina, zirconia, stabilized zirconia, boron nitride, alumino-silicate, glass-ceramic, ultra-high-molecular-weight (UHMW) polyethylene, low density polyethylene, high density polyethylene, polyvinyl chloride (PVC), acetals, nylons, polycarbonate, polyethylene terephthalate (PET-P), polyphenylsulfone, polyphenyl sulfide, PTFE, and polyether ether ketone (PEEK). In some embodiments some metals may be employed for a subset or all of the elements including, but not limited to, copper, brass, and aluminum.

Whilst the mechanical spacings may be varied within the embodiment of the invention described within Figure 15 to adjust coil positioning during flexing / adjusting of a coil assembly to decrease separation between the coil assembly and the patient's scalp. However, in some instances it may be appropriate to not only adjust vertical positions and relative vertical positions between the overlapping coils but also to adjust laterally the position of a coil or coils within the coil assembly. Accordingly, as depicted in Figure 16 in first and second sides 1600A and 1600B respectively a concept for adjustment of coil position either in conjunction with a rigid or non-deformable former or with a deformable / compliant / pliable former according to an embodiment of the invention is presented. The first and second sides 1600A and 1600B differ only in flat copper first and second coils 1410A and 1440A respectively are employed in first side 1500A whilst wire first and second coils 1410B and 1440B are employed in the second side 1500B. As depicted the first coils are attached to first bead mounts 1640A comprising a first thread hole 1650A through which a thread 1660 attaches the second coil. The first bead mounts 1640A are attached to a first spring 1630A and retained at the first bead mount 1640A and threaded slider 1470 such that the action of first drive screw 1610A allows the vertical position of the first coil to be adjusted and the threaded slider 1670 allows the first bead mount 1640A to slide along a slot 1620. In a similar manner the second coils are attached to second bead mounts 1640B comprising a second thread hole 1650B through which a thread 1660 attaches the second coil. The second bead mounts 1640B are attached to a second spring 1630B and retained at the second bead mount 1640B and threaded insert 1680 such that the action of second drive screw 1610B allows the vertical position of the second coil to be adjusted.

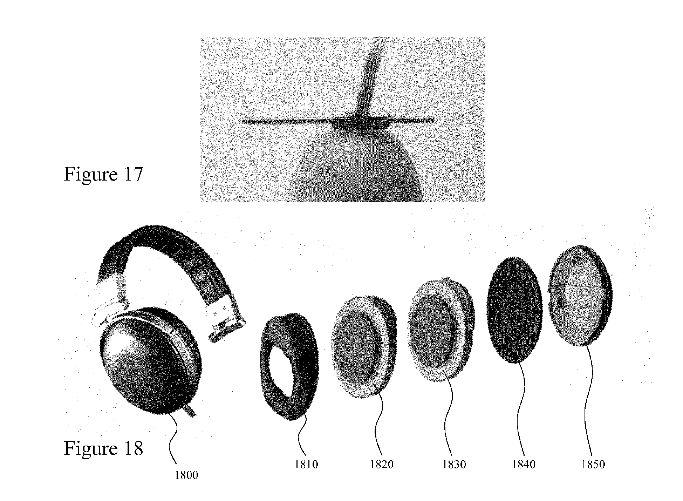

Second bead mount 1640B also has a threaded hole, not identified for clarity, through which third drive screw 1610C works to engage against first bead mount 1640A wherein the action of third spring 1630C pulls first bead mount 1640A against the third drive screw so that the relative position of the first bead mount 1640A relative to the second bead mount 1640B may be achieved as the first bead mount 1640A and assembly will slide in slot 1620 via threaded slider 1670 whilst the second bead mount is retained in position by threaded insert 1680. Optionally, the first bead mount 1640A may be retained within the preform 1650 whilst the second bead mount 1640B moves through the action of a threaded slider. Alternatively, both of the mounts may be on threaded sliders which are then restrained in position. It would be evident to one of skill in mechanical systems that a variety of other mechanical configurations may be employed to provide the required relative motion of the mounts for the coils vertically (primarily for adjusting coil position relative to the former to reduce coil - scalp gap) and laterally (primarily for adjusting coil positions relative to one another to fine tune decoupling between coils within the coil array. Such systems may employ manual, electromechanical and / or motorized elements discretely or in combination for example. Such electromechanical actuators may, for example, include piezoelectric unimorphs and piezoelectric bimorphs whilst motorized elements may, for example, include linear motors or an ultrasonic lead screw motor. Such an ultrasonic lead screw and reduced voltage linear motors with small footprint is depicted in Figure 17 and described in US Patent 6,940,209 and US Patent 8,217,553 for example.

Whilst Figure 15 depicts vertical coil positioning and Figure 16 both horizontal and vertical positioning of the coils it would be evident that within other embodiments of the invention that the coils may be adjusted solely in the horizontal direction to improve the crosstalk reduction achievable from overlapping of the coil elements. Now referring to Figure 18 there is depicted a method of addressing the acoustic noise within an MRI machine during EPI scan measurements incorporating additional coil elements according to an embodiment of the invention. As depicted a headphone 1800 for use in conjunction with an MRI system is depicted comprising deformable shell 1810, coil former and coil 1820, coil electronics 1830, micro-fiber sound absorber 1840, and housing 1850. Within an alternate embodiment of the invention insulation may be provided on the inner surface of the coil housing. In this manner, the coil housing may act essentially as a helmet whilst the insulation reduces noise getting to the patient's head. In some embodiments of the invention this insulation may be provided over the entire inner surface of the coil housing whilst in others it may be over only predetermined regions of the inner surface of the coil housing.

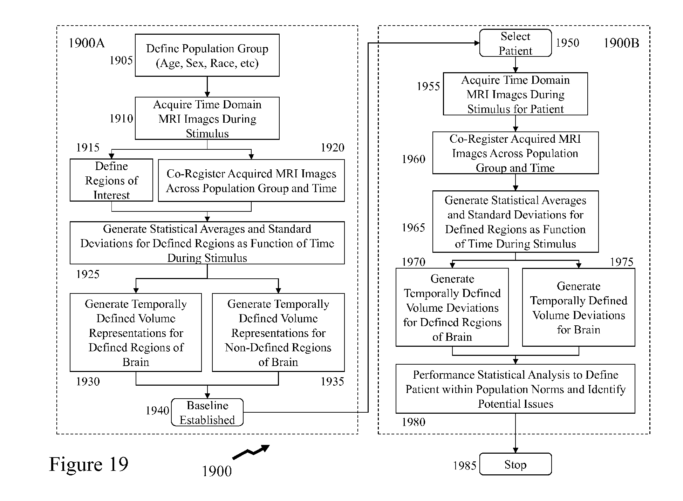

Referring to Figure 19 there is depict an exemplary flow diagram 1900 for establishing a baseline temporal MRI baseline in first sub-flow 1900A with respect to a predetermined population in response to a stimulus and exploiting said baseline in second sub-flow 1900B for analysis of potential neurological conditions according to an embodiment of the invention. The process begins in step 1905 wherein a population group is defined, such as for example by age, race, and sex. Subsequently, in step 1910 time domain MRI image data is acquired exploiting, for example, an MRI coil assembly designed for the population group as described in respect of embodiments of the invention above in respect of Figures 1 to 18 respectively. For example, the MRI coil and assembly may be designed to acquire high resolution head images for the selected population group as described above. However, in contrast to the description above the MRI image acquisition process is repeated continuously during a period of time during which the patient is exposed to a stimulus, e.g. music, audiovisual content, aroma, and suggestions. Optionally, the acquisition is time synchronized with the stimulus.

Next the process proceeds via parallel steps 1915 and 1920 respectively. In step 1920 the set of acquired MRI images for each patient and across the sample set of patients are co-registered whilst in step 1915 the regions of interest are defined within these acquired MRI images. The co-registered images are then employed in step 1925 together with the regions of interest defined in step 1915 to generate statistical average and standard deviation data for each region. From step 1925 the process proceeds to steps 1930 and 1935 in parallel. In step 1930 temporally defined volume representations of the defined regions are generated whilst in step 1935 temporally defined volume representations of the non-defined regions are generated. Based upon the data generated in steps 1930 and 1935 a baseline MRI temporal dataset and statistical data are established.

Subsequently, second sub-flow 1900B is triggered wherein a patient is selected in step 1950 for whom time domain MRI images are acquired in step 1955 when presented with the same stimulus as employed in generating the baseline dataset. These are again co-registered in step 1960 and employed to generate statistical average and standard deviation data for each region for the patient. Then in steps 1970 and 1975 temporally defined volume deviations of the defined and non-defined regions are generated for the patient relative to the baseline dataset. Subsequently in step 1980 the derived patient data is analysed statistically against the baseline MRI temporal datasets within which the patient fits to identify potential issues. In some instances a particular dataset may be specific, e.g. 80-89 year old Caucasian males, whereas in other instances datasets may be more generic such that data from multiple datasets must be considered and / or processed.

Whilst it would be evident from the discussions above that such temporal MRI scans in response to stimulus may be acquired using embodiments of the invention with high resolution within the brain using embodiments of the invention such as the visual cortex it would be evident that other MRI coils may be designed to target other regions such as those associated with smell, sound, touch, short-term memory, long-term memory, reasoning, and emotions etc. It would also be evident that other regions / portions of the human body may be similarly imaged at high resolution temporally under stimulus such as applying electrical stimuli to muscles, etc.

Within the embodiments of the invention described *supra* in Figures 4 to 18 one or more electromagnetic coils are employed to form the MRI coil array. For head-neck MRI coils these are assembled primarily within the prior art using flat foils, typically of copper. This is despite wire based coils providing improved sensitivity than foil based coils. However, copper wire is difficult to work with due to its ductility. Accordingly, the inventors within embodiments of the invention implement MRI coils using copper - beryllium wire as this provides a non-magnetic material with flexibility and resiliency. Copper alloyed with, typically, 0.5%-3.0% beryllium and sometimes other alloying elements forms the basis of copper spring materials. Optionally, such copper beryllium wire may be plated, e.g. with silver, for improved sensitivity at high fields. The use of copper-beryllium alloy wires would allow the construction of flexible wire phased array coils.

An additional element within the deployment of MRI coils addressed by the inventors is that of detuning the receiver coils during the transmit pulse. Each receiver coil element typically includes two resonant circuits, a first main circuit which receives the MRI signal during the measurements and another that basically quenches the energy at the resonant frequency. This second one is commonly referred to as the detuning circuit and is active during the transmit pulse in order to prevent the RF energy becoming focused under the receiver coil. If detuning fails, then all the RF power from the transmit coil is focused in the area of the receive coil that has the failed detuning circuit. This may result in burns or other undesirable effects for the patient. Due to this risk current commercial systems include additional electronic components for each MRI coil element. These may include a fuse and one or more passively detuned circuits where the main detuning circuit is activated by a control signal from the MRI scanner. However, these additional circuits cumulatively reduce the sensitivity of the coil and hence are undesirable from an SNR perspective, but important from a patient safety perspective.

Accordingly, it would be beneficial to provide a means, preferably digitally, of tracking and alerting to the failure of detuning circuit. Accordingly, embodiments of the invention exploit a microprocessor based monitoring methodology to monitor the signal from each coil and check for detuning failures. Assuming only the main detuning circuit is on the coil, then if this circuit breaks more RF energy is deposited under the receive channel than the pulse sequence had intended which normally manifests itself as brighter regions in an image. Accordingly, the inventors have established that the failure of a detuning circuit or multiple circuits can be measured from the free induction decay curve, the image, or anywhere in between. Accordingly, rather than introducing additional safety features that reduce sensitivity the microprocessor based monitoring can monitor the signals coming from every coil and determine whether one or more suddenly increases as indicated, for example, as a brighter region in the image. This determination may be made based upon analysis of the coil signal against other data including, but not limited to, this signal relative to others within the MRI coil array, relative to the history of this particular coil (e.g., computer log files), relative to a previous MRI of the patient, a characteristic of the patient, a characteristic of one or more populations that the patient is part of, and transmit coil power. If one or more software triggers are reached, then the monitoring software may, for example, halt the imaging sequence and / or, inform the operator that a detune failure threshold has been reached. Other actions may be triggered as well. In this manner, the coil itself can be designed for maximal SNR, while a microprocessor based monitoring system monitors the signal for signatures of detune failure. It would also be evident that the microprocessor based monitoring system may provide preemptive notification of MRI coil issues rather than merely that a failure has occurred. Optionally, other algorithms may be employed to characterise the MRI coil array and its coils for other characteristics.

The foregoing disclosure of the exemplary embodiments of the present invention has been presented for purposes of illustration and description. It is not intended to be exhaustive or to limit the invention to the precise forms disclosed. Many variations and modifications of the embodiments described herein will be apparent to one of ordinary skill in the art in light of the above disclosure. The scope of the invention is to be defined only by the claims appended hereto, and by their equivalents.

Further, in describing representative embodiments of the present invention, the specification may have presented the method and/or process of the present invention as a particular sequence of steps. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the specification should not be construed as limitations on the claims. In addition, the claims directed to the method and/or process of the present invention should not be limited to the performance of their steps in the order written, and one skilled in the art can readily appreciate that the sequences may be varied and still remain within the spirit and scope of the present invention.

## Claims

1. A magnetic resonance imaging (MRI) method comprising:
providing a magnetic resonance imaging (MRI) coil; and
performing measurements with the MRI coil.

2. The MRI method according to claim 1, wherein
providing a magnetic resonance imaging (MRI) coil comprises:
acquiring a plurality of magnetic resonance imaging (MRI) images relating to members of a predetermined subset of a population of a predetermined species, each MRI image relating to a predetermined anatomical region of the predetermined species;
applying a predetermined mathematical process to plurality of MRI images for the predetermined subset of the population of a predetermined species with respect to the predetermined anatomical region of the predetermined species;
deriving a first contour relating to a surface relating to a plurality of MRI coil elements which will form the MRI coil; and
deriving a second contour relating to a surface for accommodating the predetermined anatomical region of the predetermined species.

3. The MRI method according to claim 1, wherein
the predetermined subset of the population of the predetermined species is established in dependence upon at least one of sex, race, age and a genetic characteristic.

4. The MRI method according to claim 1, wherein
performing measurements with the MRI coil.
measuring the signal from a magnetic resonance imaging (MRI) receiver coil during operation of a transmit coil;
processing the measured signal using an algorithm to establish a signal measure;
determining whether to perform an action in dependence upon at least whether the measured signal exceeds a predetermined threshold.

5. The MRI method according to claim 4, wherein
the algorithm exploits at least one of:
measured signals from at least one other MRI receiver coil within an array comprising the measured MRI receiver coil and the other MRI receiver coil;
historical data relating to the signal from the measured MRI receiver coil;
the transmit coil signal;
data from a previous MRI performed on the patient upon whom the method is performed;
data for a population within which the patient upon whom the method is performed would be a member.

6. The MRI method according to claim 1, wherein
providing a magnetic resonance imaging (MRI) coil comprises:
assembling the MRI coil by mounting a support to a former for the coil, the support comprising a hole essentially parallel to the former when the support is mounted, and
attaching a coil element for the MRI coil to the former.

7. The MRI method according to claim 1, wherein
providing a magnetic resonance imaging (MRI) coil comprises:
adjusting the position of a coil forming part of the MRI coil, wherein
the MRI coil comprises at least a former for providing a support to which the coil is attached; and
a translation mechanism for moving the support in a direction at least one of substantially perpendicular to the surface of the former and substantially parallel to the surface of the former.

8. The MRI method according to claim 1, wherein
providing a magnetic resonance imaging (MRI) coil comprises:
adjusting positions of a coil and a second coil forming part of the MRI coil relative to a former and to one another, wherein
the MRI coil comprises:
a first support to which the first coil is attached and a first translation mechanism for moving the first support in a direction substantially parallel to the surface of the former;
a second support to which the second coil is attached and a second translation mechanism for moving the second support in a direction substantially parallel to the surface of the former; and
a third translation mechanism attached to the first and second supports for adjusting the separation between the first and second supports.

9. The MRI method according to claim 1, wherein
providing a magnetic resonance imaging (MRI) coil comprises:
establishing the design of at least one of a coil housing and a coil assembly for the MRI coil; wherein
the design accommodates a patient population comprising those patients within at least one of plus three standard deviations and minus three standard deviations from the normal of the patient population.

10. A magnetic resonance imaging (MRI) coil comprising:
a plurality of magnetic resonance imaging (MRI) coil elements; and
a body within which the MRI coil is disposed with a first contour profile and comprising a surface with a second contour profile; wherein
the first and second contour profiles are established with respect to a predetermined anatomical region of a predetermined species and a predetermined subset of the population of the predetermined species.

11. The MRI coil according to claim 10, wherein
the first and second contour profiles are established by applying a predetermined mathematical process to a plurality of MRI images for the predetermined anatomical region of the predetermined species and the predetermined subset of the population of the predetermined species.

12. The MRI coil according to claim 10, wherein
the first contour profile is established in dependence upon a region of the predetermined anatomical region of the predetermined species to be imaged with the MRI coil; and
the second contour profile relates to a physical support for the predetermined anatomical region of the predetermined species.

13. The MRI coil according to claim 10, wherein
the first contour profile is established in dependence upon a region of the human brain for the predetermined subset of the human population to be imaged with the MRI coil; and
the second contour profile relates to a predetermined region of the human skull such that over the predetermined subset of the human population to be imaged with the MRI coil the distance between the region of the human brain and the MRI coil is reduced relative to another MRI coil established based solely upon the human skull of a predetermined portion of the human population.

14. The MRI coil according to claim 10, wherein
the MRI coil is formed using a flexible, resilient non-magnetic wire.

15. The MRI coil according to claim 10, wherein
the MRI coil is formed using a wire comprising at least one of an alloy and a copper-beryllium alloy.
